# EUROPEAN PATENT SPECIFICATION

(11) **EP 2 090 479 B1**
(45) Date of publication and mention of the grant of the patent: **26.11.2014**
(21) Application number: 08101705.5
(22) Date of filing: 18.02.2008
(51) Int. Cl.: B60S 1/38

(54) **Windscreen wiper device**
Scheibenwischvorrichtung
Dispositif d'essuie-glace

(43) Date of publication of application: 19.08.2009
(73) Proprietor: Federal-Mogul S.A., 6790 Aubange (BE)
(72) Inventor: Boland, Xavier, 6700 Arlon (BE)
(74) Representative: Hooiveld, Arjen Jan Winfried

(56) References cited:
- EP-A- 1 627 787
- EP-A- 1 767 416
- EP-A1- 2 042 394
- WO-A-02/090155
- DE-A1-102006 020 524
- US-A1- 2005 011 033

## Description

The present invention relates to a windscreen wiper device comprising an elastic, elongated carrier element, as well as an elongated wiper blade, which can be placed in abutment with a windscreen to be wiped, which wiper blade includes at least one longitudinal groove, in which groove a longitudinal strip of the carrier element is disposed, wherein ends of said longitudinal strip are connected to a respective connecting piece, which windscreen wiper device comprises a connecting device for an oscillating arm.

Such a windscreen wiper device is known from international (PCT-) patent publication no. WO 02/090155 in the name of the same Applicant. The prior art windscreen wiper device is in particular designed as a "yokeless" wiper device or "flat blade", wherein use is no longer made of several yokes pivotally connected to each other, but wherein the wiper blade is biassed by the carrier element, as a result of which it exhibits a specific curvature. In this known windscreen wiper device said wiper blade includes two opposing longitudinal grooves on its longitudinal sides, in which grooves spaced-apart longitudinal strips of the carrier element are disposed. Neighbouring ends of said longitudinal strips are interconnected by said respective connecting piece.

A sometimes felt disadvantage of the windscreen wiper device as described in the above international (PCT-) patent publication is that a rubber wiping lip of said wiper blade might show a permanent deformation after several months of use, as said wiping lip has to make many oscillating movements during use, wherein said wiping lip has to bend severely. Bending the rubber of said wiping lip many times back and forth might lead to a permanent deformation of said rubber and thus to deteriorated wiping properties, with all negative consequences involved.

German patent publication no. 10 2006 020524 (Bosch) describes a windscreen wiper device according to the preamble of claim 1.

It is an object of the invention to improve the prior art, that is to improve a windscreen wiper device known from the above patent publication, wherein a permanent deformation of said wiping lip is avoided at all times.

In order to accomplish that objective, a windscreen wiper device of the kind referred to in the preamble of claim 1 according to the invention is characterized in that said reinforcement element extending in longitudinal direction has a bending stiffness in transverse direction perpendicular to the longitudinal direction of the wiper blade (2) and parallel to the windscreen to be wiped, allowing said holding part (3) to firmly retain said wiping part (4) thereon, and is flexible in longitudinal direction of the wiper blade (2) allowing said reinforcement element (20) to follow any bending of said longitudinal strip (6) along the curvature of the windscreen to be wiped, wherein said reinforcement element is provided with spaced-apart profiles extending in transverse and longitudinal directions. Hence, said reinforcement element enhances the stiffness of said holding part in transverse direction, allowing said holding part to firmly retain said wiping part thereon. Simultaneously, said reinforcement element is flexible enough to follow any bending of said longitudinal strip along the curvature of the windscreen to be wiped. Accordingly, said reinforcement element incorporates two features which at first sight appear to be incompatible, namely having a bending stiffness in transverse direction and having flexibility in longitudinal direction. This is particularly achieved by said profiles put at a distance form each other. Preferable, said side arms of said holding part pivotally engage said wiping part from the outside in a lateral region thereof, so that a mechanical articulation is realized between said holding part and said wiping part, wherein said holding part holds said wiping part allowing said wiping part to make pivotal or hingeable movements relative to said holding part during use. In use said pivotal movements of said wiping part correspond to oscillatory movements of said oscillating arm. Due to said mechanical articulation said wiping part will not have to bend to follow the oscillatory movements of said oscillating arm, so that a permanent deformation of said wiping part as a result of stress in the rubber thereof is avoided. Said reinforcement element ensures that said holding part has a flexural or bending stiffness in transverse direction, so that said holding part is allowed to firmly hold said wiping part.

In a preferred embodiment of a windscreen wiper device according to the invention, said spaced-apart profiles have a C-shaped cross-section. In the alternative, first and second spaced-apart profiles each having a C-shaped cross-section are provided, wherein said C's of said first and second profiles are different in size.

In a preferred embodiment of a windscreen wiper device in accordance with the invention, said at least one longitudinal groove having a open circumference is provided on said holding part at an upper side thereof facing away from said wiping part. Particularly, said longitudinal strip can be easily mounted inside said central groove by hand, for example. More in particular, longitudinal sides of said holding part are bend inwardly at the location of its upper side, thereby defining said longitudinal groove. Accordingly, said longitudinal strip is firmly retained inside said groove. In the alternative, said holding part has a central groove having a closed circumference.

In another preferred embodiment of a windscreen wiper device according to the invention, said side arms of said holding part pivotally engage said wiping part from the outside in a lateral region thereof. Particularly, said holding part further comprises additional downwardly extending engaging means for pivotally engaging said wiping part in an upper region thereof. Said additional engaging means ensure that a wiping lip of said wiping part is tumbled over at each turning point of its oscillary movement with the biggest reversal torque.

In another preferred embodiment of a windscreen wiper device in accordance with the invention, said wiping part comprises a wiping lip, a neck extending from said wiping lip, as well as an enlarged head extending from said neck, and wherein said enlarged head is mounted into a hollow chamber defined by said side arms of said holding part. Said enlarged head preferably has a circular, elliptical, square, rectangular, rhomboid or heart-shaped cross-section. Said wiping lip is placed in abutment with a windscreen to be wiped. Said wiping lip, said neck and said enlarged head particularly are in one piece and extend in longitudinal direction along the entire length of the wiper blade.

Particularly, said additional engaging means engage said enlarged head at the location of its upper surface. More in particular, said engaging means comprise a downwardly extending (elongated) protrusion engaging said enlarged head in a correspondingly shaped slit thereof. Preferably, said protrusion extends along the entire length of the wiper blade and is made in one piece with said holding part.

In another preferred embodiment of a windscreen wiper device according to the invention said arms of said holding part comprise inwardly extending end parts, wherein said neck is located at least partly between said end parts, and wherein the enlarged head is located above said end parts. In other words, said enlarged head is confined in said hollow chamber, wherein said hook-shaped end parts further retain said wiping part onto said holding part. Particularly, said hollow chamber comprises a lubricant in order to allow smooth pivotal movements of said wiping part without wear.

In another preferred embodiment of a windscreen wiper device according to the invention, said holding part is provided with a spoiler at a side thereof facing away from said wiping part. Said spoiler may be provided with engaging members engaging around longitudinal sides of said holding part. Preferably, said spoiler is entirely detachably connected to said holding part. In the alternative, said spoiler is in one piece with said holding part.

Said holding part and said wiping part preferably extend in longitudinal direction along the entire length of said wiper blade. In other words, said wiper blade consists of two mutually cooperating constructional elements, namely said holding part and said wiping part. Said parts are preferably slidably connected to each other, wherein said enlarged head of said wiping part is slidably mounted into said hollow chamber of said holding part. Said hollow chamber extends along the entire length of said wiper blade so as to form a channel with two open ends. One of said open ends of said channel forms an entrance through which said wiping part as a separate construction element can be slid by hand into said channel until said wiping part is finally retained onto said holding part (the first position). Said open end also acts as an exit through which said wiping part can be slid by hand from the first position until said wiping part as a separate "loose" construction element can be replaced or repaired (the second position).

Said wiping part is at least substantially made of an elastomeric material, such as rubber, wherein said holding part is at least substantially made of a plastic material. Said reinforcement element is particularly made of metal.

The invention will now be explained in more detail with reference to figures illustrated in a drawing, wherein:
- figure 1 shows a perspective view of a windscreen wiper device according to a preferred embodiment of the invention; and
- figures 2, 3 and 4 are perspective views of parts of the windscreen wiper of figure 1, partly in exploded view.

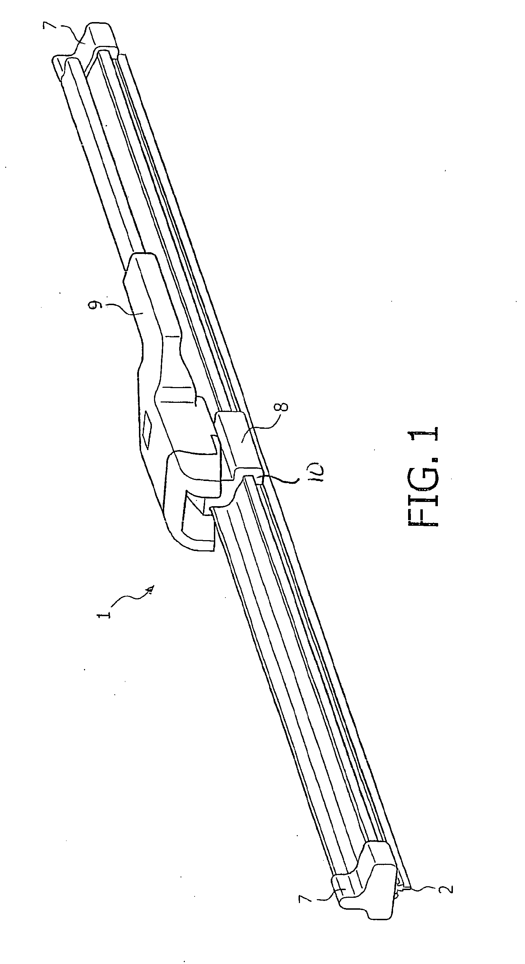

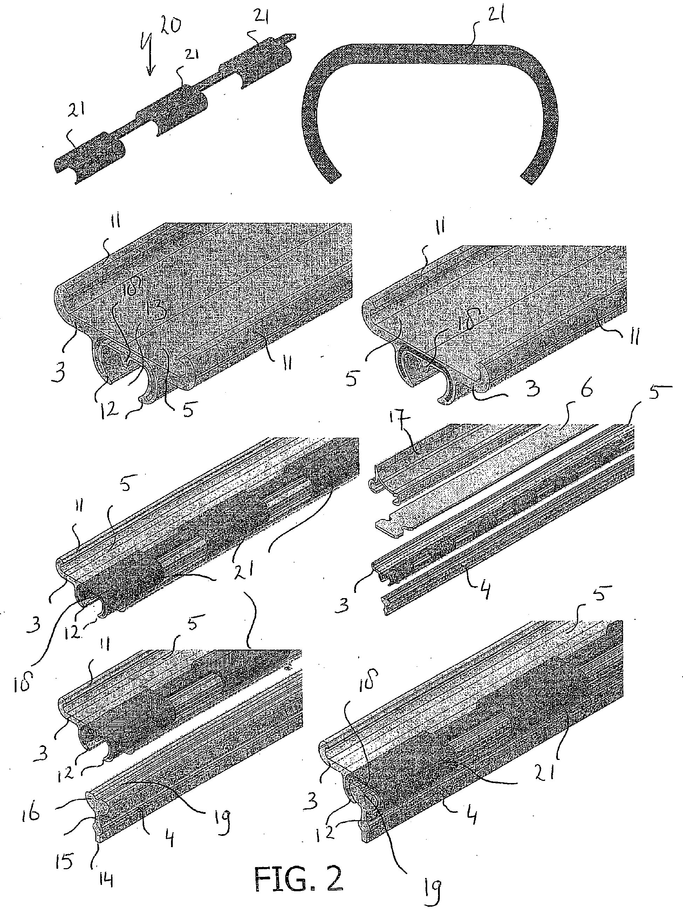

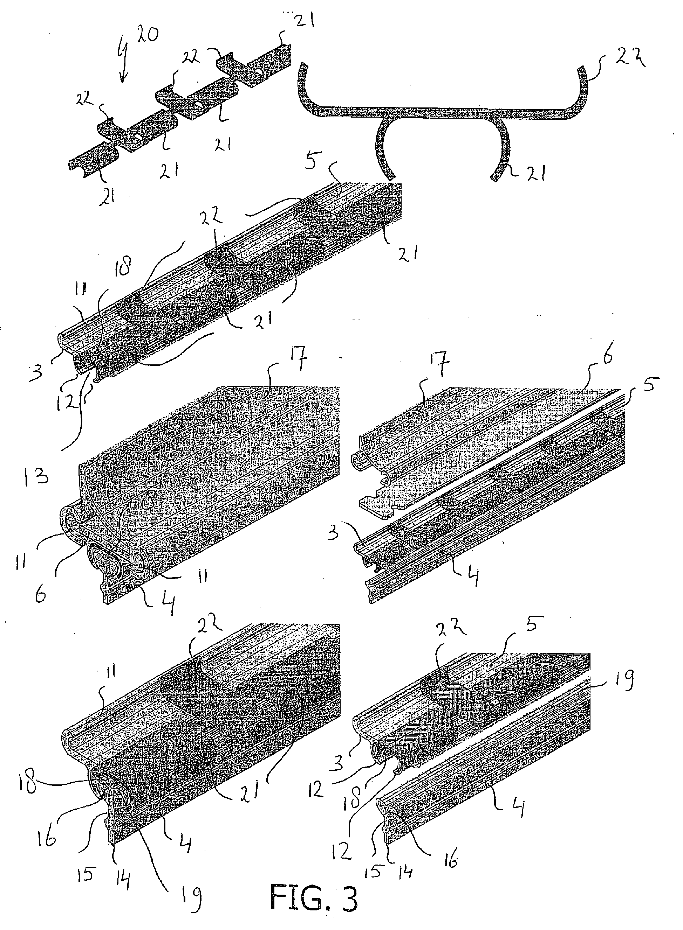

Figure 1 shows a preferred variant of a windscreen wiper device 1 according to the invention. Said windscreen wiper device 1 is built up of a wiper blade 2 consisting of a plastic elongated upper holding part 3 and an elastomeric elongated lower wiping part 4, both extending in longitudinal direction along the entire length of said wiper blade 2. In the holding part 3 a central longitudinal groove 5 is formed, in which a longitudinal strip 6 made of spring band steel is fitted (figures 2 and 3). Said strip 6 forms a flexible carrier element for the rubber wiper blade 2, as it were, which is thus biased in a curved position (the curvature in operative position being that of a windscreen to be wiped). Outer ends of said strip 6 are connected on either side of the windscreen wiper device 1 to connecting pieces 7 functioning as clamping members. In this embodiment, the connecting pieces 7 are separate constructional elements, which may be form-locked as well as force-locked to the outer ends of said strip 6. In another preferred variant, said connecting pieces 7 are in one piece with the strip 6 made of spring band steel.

The windscreen wiper device 1 is furthermore built up of a connecting device 8 of plastic or metallic material for an oscillating wiper arm 9. Said connecting device 8 comprises clamping members 10 that are integral therewith, which engage round longitudinal sides 11 of the holding part 3 that face away from each other, as a result of which the connecting device 8 is firmly attached to the unit consisting of the holding part 3 and the strip 6. Likewise, the connecting pieces 7 comprise similar clamping members. The oscillating wiper arm 9 is pivotally connected to the connecting device 8 about a pivot axis near one end thereof.

As can be seen from figures 2 and 3, said holding part 3 is provided with downwardly extending side arms 12 in one piece therewith, seen in cross-section, thus defining a hollow chamber or space 13, again seen in cross-section. Said hollow chamber 13 extends in longitudinal direction along the entire length of said wiper blade 2, so as to form a channel with two open outer ends. Again referring to figures 2 and 3, said wiping part 4 consists of a wiping lip 14, a neck 15 extending from said wiping lip 14, as well as an enlarged head 16 extending from said neck 15 and having a heart-shaped cross-section. Said parts 3,4 are slidably connected to each other, wherein said enlarged head 16 of said wiping part 4 is slidably mounted into said hollow channel of said holding part 3. One of said open ends of said channel forms an entrance through which said wiping part 4 as a separate construction element can be slid by hand into said channel until said wiping part 4 is finally retained onto said holding part 3 (the first or holding position). Said open end also acts as an exit through which said wiping part 4 can be slid by hand from the first position until said wiping part 4 as a separate "loose" construction element can be replaced or repaired (the second position). The side arms 12 of said holding part 3 pivotally engage the enlarged head 16 of said wiping part 4, so as to allow a pivotal or hingeable movement of said wiping part 4 when the oscillating wiper arm 9 attached to said holding part 3 makes a corresponding oscillatory movement.

As shown, said holding part 3 is connected to a detachable spoiler 17 at a side thereof facing away from said wiping part 4, wherein said spoiler 17 is equipped with engaging members engaging around longitudinal sides 11 of said holding part 3. Said longitudinal sides 11 are bend inwardly to firmly retain said longitudinal strip 6 inside said groove 5.

With reference to figures 2 and 3, a bottom of said holding part 3 is provided with additional engaging means in the form of a downwardly extending protrusion 18 which extends in longitudinal direction along a part of the length of said wiper blade 2 or along the entire length thereof. Said protrusion 18 engages into a correspondingly shaped slit 19 provided on an upper surface of said hollow chamber 13 by means of free ends of said side arms 12 and said protrusion 18. Hence, an unstable design is obtained, wherein the torque is maximal when said wiping lip 14 tumbles over at each turning point of its oscillatory movement.

Said holding part 3 is provided with a elongated reinforcement 20 element in one piece of metal, wherein said holding part 3 and said reinforcement element 20 are mutually connected through co-extrusion. Said reinforcement element 20 extending in longitudinal direction along the entire length of said holding part 3 has a bending stiffness in transverse direction and is flexible in longitudinal direction. This is realized by providing said reinforcement element 20 with spaced-apart profiles 21 having a C-shaped or U-shaped cross-section (figure 2) and extending in transverse and longitudinal directions. In other words, by removing (cutting, sawing, stamping, for example) material at regular distances from the C-shape, a reinforcement element 20 is obtained with profiles 21 having a C-shaped or U-shaped cross-section and being positioned at a constant distances from each other. With reference to figure 3, first and second spaced-apart profiles 21,22 each having a C-shaped cross-section are provided, wherein the C of said first profiles 21 is smaller than the C of said second profiles 22. In both embodiments said reinforcement element 20 enhances the stiffness of said holding part 3 in transverse direction, allowing said holding part 3 to firmly retain said wiping part 4 thereon. Simultaneously, said reinforcement element 20 is flexible enough to follow any bending of said longitudinal strip 6 along the curvature of the windscreen to be wiped. Accordingly, said reinforcement element 20 incorporates two features which at first sight appear to be incompatible, namely having a bending stiffness in transverse direction and having flexibility in longitudinal direction. This is particularly achieved by said profiles 21,22 put at a distance from each other.

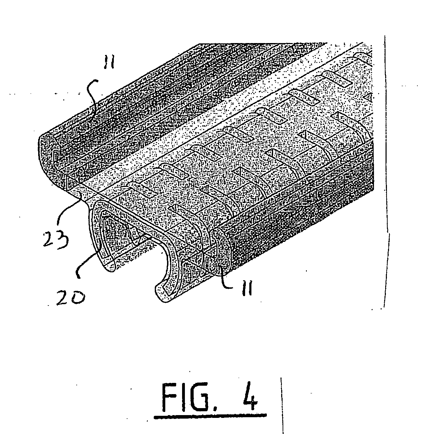

Figure 4 corresponds to figures 2 and 3, albeit that another embodiment of said reinforcement element 20 is shown. Further, longitudinal sides 11 of said holding part 3 are coextruded relative to the central part 23 of said holding part 3, wherein said longitudinal sides 11 are made of a stiffer material compared to the material of said central part 23.

Although not depicted in the figures, it will be clear for a person skilled in the art that the oscillating wiper arm 9 is connected to a mounting head fixed for rotation to a shaft driven by a small motor. In use, the shaft rotates alternately in a clockwise and in a counter-clockwise sense carrying the mounting head into rotation also, which in turn draws the oscillating wiper arm 9 into rotation and by means of the connecting device 8 moves the wiper blade 2.

The invention is not restricted to the embodiments shown, but also extends to other preferred variants falling within the scope of the appended claims. For example, a skilled person would easily understand that the central longitudinal strip 6 of figures 2 and 3 could well be replaced by two longitudinal strips 6 located in correspondingly shaped grooves 5 in said holding part 3.

## Claims

1. A windscreen wiper device (1) comprising an elastic, elongated carrier element, as well as an elongated wiper blade (2), which can be placed in abutment with a windscreen to be wiped, which wiper blade (2) includes at least one longitudinal groove (5), in which groove (5) a longitudinal strip (6) of the carrier element is disposed, wherein ends of said longitudinal strip (6) are connected to a respective connecting piece (7), which windscreen wiper device (1) comprises a connecting device (8) for an oscillating arm (9), wherein said wiper blade (2) comprises an elongated upper holding part (3) and an elongated lower wiping part (4) of a flexible material, wherein said holding part (3) holds said wiping part (4), wherein said holding part (3) comprises downwardly extending side arms (12), seen in cross-section, for holding said wiping part (4) from the outside in a lateral region thereof, wherein said holding part (3) is provided with a elongated reinforcement element (20), and wherein said holding part (3) and said reinforcement element (20) are mutually connected through co-extrusion, wherein said reinforcement element (20) extending in longitudinal direction has a bending stiffness in transverse direction perpendicular to the longitudinal direction of the wiper blade (2) and parallel to the windscreen to be wiped, allowing said holding part (3) to firmly retain said wiping part (4) thereon, and is flexible in longitudinal direction of the wiper blade (2) allowing said reinforcement element (20) to follow any bending of said longitudinal strip (6) along the curvature of the windscreen to be wiped, **characterised in that** said reinforcement element (20) is provided with spaced-apart profiles (21) extending in transverse and longitudinal directions.

2. A windscreen wiper device (1) according to claim 1, wherein said spaced-apart profiles (21) have a C-shaped cross-section.

3. A windscreen wiper device (1) according to claim 1 or 2, wherein first and second spaced-apart profiles (21, 22) having a C-shaped cross-section are provided, and wherein said C's of said first and second profiles are different in size.

4. A windscreen wiper device (1) according to any of the preceding claims 1,2 or 3, wherein said at least one longitudinal groove (5) having a open circumference is provided on said holding part (3) at an upper side thereof facing away from said wiping part (4).

5. A windscreen wiper device (1) according to any of the preceding claims 1 through 4, wherein said side arms (12) of said holding part (3) pivotally engage said wiping part (4) from the outside in a lateral region thereof.

6. A windscreen wiper device (1) according to claim 5, wherein said holding part (3) further comprises additional downwardly extending engaging means for pivotally engaging said wiping part (4) in an upper region thereof.

7. A windscreen wiper device (1) according to any of the preceding claims 1 through 6, wherein said wiping part (4) comprises a wiping lip (14), a neck (15) extending from said wiping lip (14), as well as an enlarged head (16) extending from said neck (15), and wherein said enlarged head (16) is mounted into a hollow chamber (13) defined by said side arms (12) of said holding part (3).

8. A windscreen wiper device (1) according to claim 7, wherein said enlarged head (16) has a circular, elliptical, square, rectangular, rhomboid or heart-shaped cross-section.

9. A windscreen wiper device (1) according to claim 6 or 8, wherein said additional engaging means engage said enlarged head (16).

10. A windscreen wiper device (1) according to claim 9, wherein said additional engaging means comprise a downwardly extending protrusion (18) engaging said enlarged head (16) in a slit (19) thereof.

11. A windscreen wiper device (1) according to any of the preceding claims 7 through 10, wherein said side arms (12) of said holding part (3) comprise inwardly extending end parts, and wherein said neck (15) is located at least partly between said end parts and the enlarged head (16) is located above said end parts.

12. A windscreen wiper device (1) according to any of the preceding claims 7 through 11, wherein said hollow chamber (13) comprises a lubricant.

13. A windscreen wiper device (1) according to any of the preceding claims 1 through 12, wherein said holding part (3) is provided with a spoiler (17) at a side thereof facing away from said wiping part (4).

14. A windscreen wiper device (1) according to claim 13, wherein said spoiler (17) is detachably connected to said holding part (3) .

15. A windscreen wiper device (1) according to claim 13 or 14, wherein said spoiler (17) is provided in one piece therewith with engaging members engaging around longitudinal sides (11) of said holding part (3).

## Patentansprüche

1. Scheibenwischervorrichtung (1), umfassend ein elastisches, längliches Trägerelement, wie auch längliches Wischerblatt (2), das an einer zu wischenden Scheibe anliegend platziert werden kann,
wobei das Wischerblatt (2) mindestens eine Längsrille (5) einschließt,
wobei in der Längsrille (5) ein Längsstreifen (6) des Trägerelements angeordnet ist,
wobei Enden des Längsstreifens (6) mit einem entsprechenden Verbindungstück (7) verbunden sind,
wobei die Scheibenwischervorrichtung (1) eine Verbindungsvorrichtung (8) für einen sich hin und her bewegenden Arm (9) umfasst,
wobei das Wischerblatt (2) einen länglichen oberen Halteteil (3) und einen länglichen unteren Wischteil (4) aus einem flexiblen Material umfasst,
wobei der Halteteil (3) den Wischteil (4) hält,
wobei der Halteteil (3) sich im Querschnitt nach unten erstreckende Seitenarme (12) umfasst, um den Wischteil (4) von außen in einem seitlichen Bereich davon zu halten, wobei der Halteteil (3) mit einem länglichen Verstärkungselement (20) versehen ist, und
wobei der Halteteil (3) und das Verstärkungselement (20) durch Koextrusion miteinander verbunden sind,
wobei das sich in Längsrichtung erstreckende Verstärkungselement (20) eine Biegesteifigkeit in Querrichtung senkrecht zu der Längsrichtung des Wischerblatts (2) und parallel zu der zu wischenden Scheibe aufweist, was es dem Halteteil (3) gestattet, den Wischteil (4) fest daran festzuhalten, und in Längsrichtung des Wischerblatts (2) flexibel ist und es so dem Verstärkungselement (20) gestattet, einer Biegung des Längsstreifens (6) entlang der Krümmung der zu wischenden Scheibe zu folgen,
**dadurch gekennzeichnet, dass** das Verstärkungselement (20) mit voneinander beabstandeten Profilen (21) versehen ist, die sich in Quer- und Längsrichtung erstrecken.

2. Scheibenwischervorrichtung (1) gemäß Anspruch 1,
wobei die voneinander beabstandeten Profile (21) einen c-förmigen Querschnitt aufweisen.

3. Scheibenwischervorrichtung (1) gemäß Anspruch 1 oder 2,
wobei voneinander beabstandete erste und zweite Profile (21, 22) mit c-förmigem Querschnitt bereitgestellt sind, und
wobei die Cs des ersten und des zweiten Profils in der Größe verschieden sind.

4. Scheibenwischervorrichtung (1) gemäß einem der vorstehenden Ansprüche 1, 2 oder 3,
wobei die mindestens eine Längsrille (5), die einen offenen Umfang aufweist, auf dem Halteteil (3) an einer oberen Seite davon bereitgestellt ist, die von dem Wischteil (4) weg weist.

5. Scheibenwischervorrichtung (1) gemäß einem der vorstehenden Ansprüche 1 bis 4, wobei die Seitenarme (12) des Halteteils (3) schwenkbar mit dem Wischteil (4) in Eingriff stehen, von außen in einem seitlichen Bereich davon.

6. Scheibenwischervorrichtung (1) gemäß Anspruch 5, wobei das Halteteil (3) weiter sich nach unten erstreckende Eingriffsmittel umfasst, um schwenkbar mit dem Wischteil (4) in Eingriff stehen, in einem oberen Bereich davon.

7. Scheibenwischervorrichtung (1) gemäß einem der vorstehenden Ansprüche 1 bis 6, wobei der Wischteil (4) eine Wischlippe (14), einen Hals (15), der sich von der Wischlippe (14) aus erstreckt, wie auch einen vergrößerten Kopf (16), der sich von dem Hals (15) aus erstreckt, umfasst, und
wobei der vergrößerte Kopf (16) in einer hohlen Kammer (13) angebracht ist, die durch die Seitenarme (12) des Halteteils (3) definiert ist.

8. Scheibenwischervorrichtung (1) gemäß Anspruch 7, wobei der vergrößerte Kopf (16) einen kreisförmigen, elliptischen, quadratischen, rechteckigen, rombusförmigen oder herzförmigen Querschnitt aufweist.

9. Scheibenwischervorrichtung (1) gemäß Anspruch 6 oder 8, wobei das zusätzliche Eingriffsmittel mit dem vergrößerten Kopf (16) in Eingriff steht.

10. Scheibenwischervorrichtung (1) gemäß Anspruch 9, wobei das zusätzliche Eingriffsmittel einen sich nach unten erstreckenden Vorsprung (18) umfasst, der mit dem vergrößerten Kopf (16) in einem Schlitz (19) davon in Eingriff steht.

11. Scheibenwischervorrichtung (1) gemäß einem der vorstehenden Ansprüche 7 bis 10, wobei die Seitenarme (12) des Halteteils (3) sich einwärts erstreckende End-Teile umfassen, und
wobei der Hals (15) zumindest teilweise zwischen den Endteilen angeordnet ist, und wobei der vergrößerte Kopf (16) über den Endteilen angeordnet ist.

12. Scheibenwischervorrichtung (1) gemäß einem der vorstehenden Ansprüche 7 bis 11, wobei die hohle Kammer (13) ein Schmiermittel umfasst.

13. Scheibenwischervorrichtung (1) gemäß einem der vorstehenden Ansprüche 1 bis 12, wobei der Halteteil (3) an einer Seite davon mit einem Spoiler (17) versehen ist, die von dem Wischteil (4) weg weist.

14. Scheibenwischervorrichtung (1) gemäß Anspruch 13, wobei der Spoiler (17) lösbar mit dem Halteteil (3) verbunden ist.

15. Scheibenwischervorrichtung (1) gemäß Anspruch 13 oder 14, wobei der Spoiler einstückig mit Eingriffselementen versehen ist, die um Längsseiten (11) des Halteteils (3) in Eingriff stehen.

## Revendications

1. Dispositif d'essuie-glace (1) comprenant un élément porteur allongé élastique, ainsi qu'un balai d'essuie-glace (2) qui peut être placé en butée avec un pare-brise à essuyer, lequel balai d'essuie-glace (2) comprend au moins une rainure longitudinale (5), dans laquelle rainure (5), est disposée une bande longitudinale (6) de l'élément porteur, dans lequel des extrémités de ladite bande longitudinale (6) sont raccordées à une pièce de raccordement (7) respective, lequel dispositif d'essuie-glace (1) comprend un dispositif de raccordement (8) pour un bras oscillant (9), dans lequel ledit balai d'essuie-glace (2) comprend une partie de support supérieure allongée (3) et une partie d'essuyage inférieure allongée (4) réalisée avec un matériau flexible, dans lequel ladite partie de support (3) supporte ladite partie d'essuyage (4), dans lequel ladite partie de support (3) comprend des bras latéraux (12) s'étendant vers le bas, observés en coupe, pour maintenir ladite partie d'essuyage (4) depuis l'extérieur dans sa région latérale, dans lequel ladite partie de support (3) est prévue avec un élément de renforcement allongé (20), et dans lequel ladite partie de support (3) et ledit élément de renforcement (20) sont mutuellement raccordés par co-extrusion, dans lequel ledit élément de renforcement (20) s'étendant dans la direction longitudinale a une rigidité à la flexion dans la direction transversale perpendiculaire à la direction longitudinale du balai d'essuie-glace (2) et parallèle au pare-brise à essuyer, permettant à ladite partie de support (3) de retenir fermement ladite partie d'essuyage (4) sur cette dernière, et est flexible dans la direction longitudinale du balai d'essuie-glace (2), permettant audit élément de renforcement (20) de suivre n'importe quelle flexion de ladite bande longitudinale (6) le long de la courbure du pare-brise à essuyer, **caractérisé en ce que** ledit élément de renforcement (20) est prévu avec des profilés espacés (21) s'étendant dans les directions transversale et longitudinale.

2. Dispositif d'essuie-glace (1) selon la revendication 1, dans lequel lesdits profilés espacés (21) ont une section transversale en forme de C.

3. Dispositif d'essuie-glace (1) selon la revendication 1 ou la revendication 2, dans lequel on prévoit des premier et second profilés espacés (21, 22) ayant une section transversale en forme de C, et dans lequel lesdits C desdits premier et second profilés sont différents du point de vue de la taille.

4. Dispositif d'essuie-glace (1) selon l'une quelconque des revendications 1, 2 ou 3, dans lequel ladite au moins une rainure longitudinale (5) ayant une circonférence ouverte est prévue sur ladite partie de support (3) au niveau de son côté supérieur orienté à l'opposé de ladite partie d'essuyage (4).

5. Dispositif d'essuie-glace (1) selon l'une quelconque des revendications 1 à 4, dans lequel lesdits bras latéraux (12) de ladite partie de support (3) mettent en prise de manière pivotante ladite partie d'essuyage (4) depuis l'extérieur dans sa région latérale.

6. Dispositif d'essuie-glace (1) selon la revendication 5, dans lequel ladite partie de support (3) comprend en outre des moyens de mise en prise supplémentaires s'étendant vers le bas pour mettre en prise de manière pivotante ladite partie d'essuyage (4) dans sa région supérieure.

7. Dispositif d'essuie-glace (1) selon l'une quelconque des revendications 1 à 6, dans lequel ladite partie d'essuyage (4) comprend une lèvre d'essuyage (14), un col (15) s'étendant à partir de ladite lèvre d'essuyage (14), ainsi qu'une tête élargie (16) s'étendant à partir dudit col (15), et dans lequel ladite tête élargie (16) est montée dans une chambre creuse (13) définie par lesdits bras latéraux (12) de ladite partie de support (3).

8. Dispositif d'essuie-glace (1) selon la revendication 7, dans lequel ladite tête élargie (16) a une section transversale circulaire, elliptique, carrée, rectangulaire, parallélogramme ou en forme de coeur.

9. Dispositif d'essuie-glace (1) selon la revendication 6 ou la revendication 8, dans lequel lesdits moyens de mise en prise supplémentaires mettent en prise ladite tête élargie (16).

10. Dispositif d'essuie-glace (1) selon la revendication 9, dans lequel lesdits moyens de mise en prise supplémentaires comprennent une saillie (18) s'étendant vers le bas, mettant en prise ladite tête élargie (16) dans sa fente (19).

11. Dispositif d'essuie-glace (1) selon l'une quelconque des revendications 7 à 10, dans lequel lesdits bras latéraux (12) de ladite partie de support (3) comprennent des parties d'extrémité s'étendant vers l'intérieur, et dans lequel ledit col (15) est positionné au moins partiellement entre lesdites parties d'extrémité et la tête élargie (16) est positionnée au-dessus desdites parties d'extrémité.

12. Dispositif d'essuie-glace (1) selon l'une quelconque des revendications 7 à 11, dans lequel ladite chambre creuse (13) comprend un lubrifiant.

13. Dispositif d'essuie-glace (1) selon l'une quelconque des revendications 1 à 12, dans lequel ladite partie de support (3) est prévue avec un déflecteur (17) au niveau de son côté orienté à l'opposé de ladite partie d'essuyage (4).

14. Dispositif d'essuie-glace (1) selon la revendication 13, dans lequel ledit déflecteur (17) est raccordé de manière détachable à ladite partie de support (3).

15. Dispositif d'essuie-glace (1) selon la revendication 13 ou la revendication 14, dans lequel ledit déflecteur (17) est prévu d'un seul tenant avec des éléments de mise en prise se mettant en prise autour des côtés longitudinaux (11) de ladite partie de support (3).
